# FASCICULE DE BREVET EUROPEEN

(11) **EP 3 394 792 B1**
(45) Date de publication et mention de la délivrance du brevet: **24.08.2022**
(21) Numéro de dépôt: 16812966.6
(22) Date de dépôt: 21.12.2016
(51) Int. Cl.: G06V 40/13, H01L 27/32, H01L 27/146

(54) **CAPTEUR D'EMPREINTES À ECLAIRAGE OLED**
OLED-BELEUCHTETER HAUTABDRUCKSENSOR
OLED-ILLUMINATED SKIN PRINT SENSOR

(30) Priorité: 23.12.2015 FR 1563178
(43) Date de publication de la demande: 31.10.2018
(73) Titulaire: Commissariat à l'Energie Atomique et aux Energies Alternatives, 75015 Paris (FR); Idemia Identity & Security France, 92130 Issy-les-Moulineaux (FR)
(72) Inventeur: MAINGUET, Jean-François, 38100 Grenoble (FR); BOUTET, Jérôme, 38640 Claix (FR); FOURRE, Joël Yann, 78160 Marly Le Roi (FR); TEMPLIER, François, 38000 Grenoble (FR)
(74) Mandataire: Brevalex
(86) Numéro de dépôt international: PCT/EP2016/082062
(87) Numéro de publication internationale: WO 2017/108881

(56) Documents cités:
- JP-A- 2003 037 708
- US-A1- 2008 317 303
- US-A1- 2012 256 089

## Description

### DOMAINE TECHNIQUE

L'invention se rapporte au domaine des capteurs pour imager une empreinte liée aux plis particuliers de la peau, en particulier une empreinte digitale, mais également une empreinte palmaire, plantaire, ou phalangeaire. Ces diverses empreintes sont désignées ensemble sous le terme d'empreintes papillaires.

### ÉTAT DE LA TECHNIQUE ANTÉRIEURE

On connaît dans l'art antérieur différents capteurs d'empreintes papillaires, en particulier des capteurs de type optique, dans lesquels l'acquisition d'une image de l'empreinte met simplement en œuvre un éclairage de l'empreinte puis une acquisition d'image à l'aide d'un composant photosensible.

Ces capteurs de type optique se présentent généralement sous la forme d'un empilement comprenant une couche inférieure émettrice de lumière, dite de rétroéclairage, une matrice de photo-détecteurs, et le cas échéant une couche transparente de protection sur laquelle l'utilisateur doit positionner son doigt. De tels capteurs sont connus de US2012256089 A1, US2008317303 A1, ou JP2003037708 A.

Un objectif de la présente invention est de proposer un capteur d'empreintes papillaires de type optique, permettant d'obtenir *in fine* une image de qualité améliorée, en comparaison avec les dispositifs de l'art antérieur.

### EXPOSÉ DE L'INVENTION

Cet objectif est atteint avec un capteur d'empreintes papillaires selon la revendication 1 comprenant, superposés, une surface de contact pour y appliquer l'empreinte à imager, un capteur optique matriciel, et des moyens d'éclairage.

Selon l'invention, les moyens d'éclairage sont disposés entre ladite surface de contact et une surface de détection du capteur optique matriciel.

Ils sont constitués d'une pluralité de diodes électroluminescentes organiques, dites OLED, chaque OLED s'étendant d'un seul tenant sur plus d'un tiers d'une largeur de ladite surface de détection, et les OLED s'étendant ensemble selon une ou deux séries de motifs parallèles entre eux répartis selon la longueur de la surface de détection.

Selon l'invention, les moyens d'éclairage sont formés par des OLED.

Les connaissances générales de l'homme du métier l'auraient conduit à disposer des OLED sous le capteur optique matriciel, formant le composant photosensible décrit en introduction.

Une idée à la base de l'invention consiste à remarquer qu'il est plus avantageux de disposer les OLED au-dessus d'une surface de détection du capteur optique matriciel. Cet agencement permet que les OLED et le capteur optique matriciel soient réalisés au cours d'un même processus de fabrication, sur un substrat unique.

Afin d'offrir une grande modularité d'éclairage, les moyens d'éclairage sont formés par une pluralité de diodes électroluminescentes. Les connaissances générales de l'homme du métier l'auraient conduit à disposer les OLED en matrice d'OLED, selon une grille de plusieurs lignes et plusieurs colonnes, une OLED étant placée à chaque intersection d'une ligne et une colonne. Il aurait notamment prévu une OLED pour chaque pixel du capteur optique matriciel.

L'invention propose ici de s'affranchir de ce préjugé. Les OLED selon l'invention forment donc simplement une ou deux séries de motifs parallèles formés chacun d'un seul tenant.

Les OLED peuvent ainsi être pilotées depuis le bord du capteur d'empreintes papillaires, sans que les moyens de pilotage ne s'étendent entre deux OLED, au-dessus du centre de la surface de détection.

Par ailleurs, cette configuration des OLED en lignes permet d'acquérir différentes images d'une empreinte papillaire, correspondant à l'allumage de différentes séries de lignes d'OLED, ces images pouvant être combinées pour obtenir une image de qualité améliorée.

En outre, le capteur d'empreintes papillairesne nécessite pas l'emploi de microlentilles disposées, sous forme matricielle, entre la surface de contact et le capteur matricielle, et permet ainsi la mise en œuvre d'un capteur compact.

De préférence, chaque OLED est reliée à une unité de pilotage, agencée pour piloter l'allumage et l'extinction de l'OLED, une projection orthogonale des unités de pilotage dans le plan de la surface de détection étant située à l'extérieur de ladite surface de détection.

Une distance entre le capteur optique matriciel et la surface de contact est inférieure à 25 µm.

Une telle distance confère au capteur d'empreintes papillaires une grande ouverture numérique, et permet ainsi l'obtention d'images d'empreintes, posées sur la surface de contact, présentant un contraste amélioré.

Chaque OLED peut s'étendre d'un seul tenant sur plus de 90% la largeur de ladite surface de détection, les OLED s'étendant ensemble selon une unique série de motifs parallèles entre eux.

De préférence, les moyens d'éclairage sont constitués d'OLED de différents types, qui diffèrent par la longueur d'onde centrale du rayonnement lumineux qu'elles sont adaptées à émettre.

Les OLED peuvent comprendre chacune un filtre spectral et partager ensemble une même couche semi-conductrice organique adaptée à émettre un rayonnement multi-spectral, et les différents types d'OLED peuvent ne différer par la longueur d'onde centrale de la bande de transmission du filtre spectral.

Avantageusement, chaque OLED présente deux longueurs d'onde centrales d'émission distincte, selon la valeur d'une tension de polarisation qui lui est appliquée, et les différents types d'OLED diffèrent par la tension de polarisation fournie par une unité de pilotage connectée à l'OLED.

Les diodes électroluminescentes organiques comprennent de préférence au moins un premier type de diode électroluminescente organique, adapté à émettre un rayonnement lumineux de longueur d'onde centrale inférieure à 590 nm, et un deuxième type de diode électroluminescente organique, adapté à émettre un rayonnement lumineux de longueur d'onde centrale supérieure à 600 nm.

L'absorption par des tissus vivants (en particulier les tissus de la peau) présente une variation importante à la longueur d'onde 600 nm, et il est ainsi possible d'extraire deux informations sensiblement différentes dès lors qu'un premier type de diode électroluminescente organique, adapté à émettre un rayonnement lumineux de longueur d'onde centrale inférieure à 590 nm, et un deuxième type de diode électroluminescente organique, adapté à émettre un rayonnement lumineux de longueur d'onde centrale supérieure à 600 nm, sont mis en oeuvre.

Avantageusement, les OLED comprennent :
- un premier type d'OLED, adapté à émettre un rayonnement lumineux de longueur d'onde centrale comprise entre 400 et 495 nm,
- un deuxième type d'OLED, adapté à émettre un rayonnement lumineux de longueur d'onde centrale comprise entre 495 et 590 nm, et
- un troisième type de d'OLED, adapté à émettre un rayonnement lumineux de longueur d'onde centrale supérieure à 600 nm.

Les OLED peuvent former ensemble un agencement périodique, avec un motif élémentaire comprenant lesdits plusieurs types d'OLED.

Les OLED peuvent former ensemble un agencement périodique, avec un motif élémentaire tel que le pas de répétition moyen d'un type d'OLED adapté à émettre à une première longueur d'onde est inférieur au pas de répétition moyen d'un type d'OLED adapté à émettre à une seconde longueur d'onde supérieure à la première longueur d'onde.

Chaque OLED peut présenter une forme de bande, les OLED formant ensemble des bandes parallèles entre elles.

De préférence, chaque OLED s'étend au-dessus du capteur optique matriciel, sans recouvrir les zones photosensibles des pixels du capteur optique matriciel.

Les OLED sont avantageusement transparentes et s'étendent au-dessus du capteur optique matriciel (120 ; 320) en recouvrant les zones photosensibles des pixels dudit capteur.

De préférence, les OLED sont réparties régulièrement selon la longueur de la surface de détection du capteur optique matriciel, avec un pas de répétition égal au pas de pixel du capteur optique matriciel selon ladite longueur.

### BRÈVE DESCRIPTION DES DESSINS

La présente invention sera mieux comprise à la lecture de la description d'exemples de réalisation donnés à titre purement indicatif et nullement limitatif, en faisant référence aux dessins annexés sur lesquels :
- la figure 1A illustre de façon schématique une vue de dessus d'un premier mode de réalisation d'un capteur d'empreintes papillaires selon l'invention ;
- les figures 1B et 1C illustrent de façon schématique des vues en coupe selon deux axes orthogonaux, du capteur d'empreintes illustré en figure 1A ;
- la figure 2 illustre un exemple d'un capteur d'empreintes papillaire tel que représenté schématiquement sur les figures 1A à 1C ;
- la figure 3 illustre un deuxième mode de réalisation d'un capteur d'empreintes papillaires selon l'invention ;
- la figure 4 illustre un troisième mode de réalisation d'un capteur d'empreintes papillaires selon l'invention ;
- les figures 5 et 6 illustrent deux modes de réalisation d'un capteur d'empreintes papillaires selon l'invention, comprenant des moyens de pilotage des OLED ; et
- les figures 7A et 7B illustrent de façon schématique deux modes de réalisation d'un capteur d'empreintes papillaires selon l'invention, présentant des OLED de différents types adaptés à émettre à différentes longueurs d'onde.

### EXPOSÉ DÉTAILLÉ DE MODES DE RÉALISATION PARTICULIERS

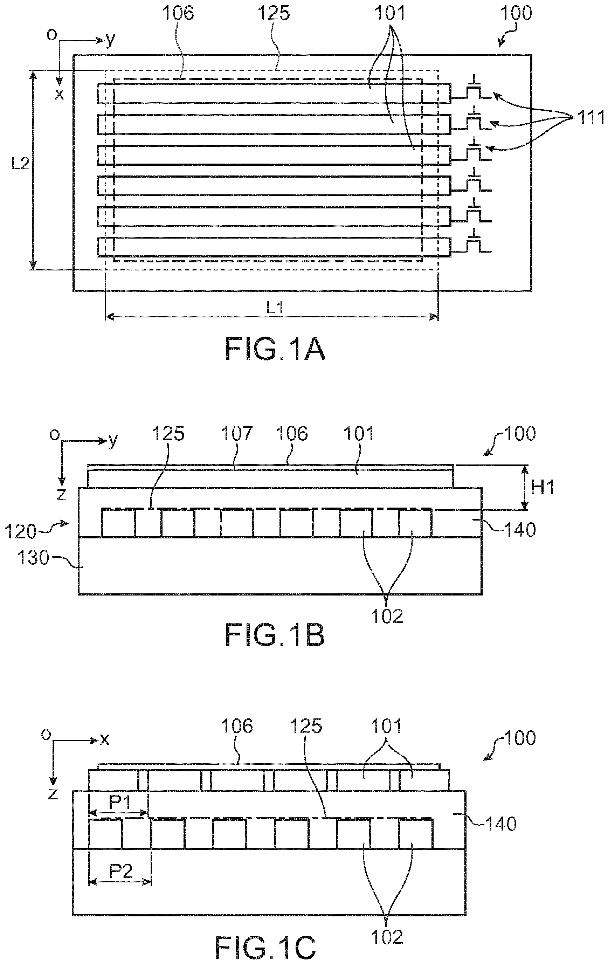

Les figures 1A à 1C illustrent de façon schématique un premier mode de réalisation d'un capteur d'empreintes papillaires selon l'invention. Dans la suite, on considérera, à titre d'exemple et de manière non limitative, qu'il s'agit d'un capteur d'empreintes digitales 100.

La figure 1A est une vue de dessus de ce capteur, dans un plan (XOY), tandis que les figures 1B et 1C sont des vues en coupe respectivement dans un plan orthogonal au plan (XOY) et parallèle à l'axe (OY), et dans un plan orthogonal au plan (XOY) et parallèle à l'axe (OX).

La figure 1A illustre plus particulièrement les moyens d'éclairage du capteur selon l'invention, formés par des diodes électroluminescentes 101, dites OLED pour « *Organic Light-Emitting Diode* ». Le capteur d'empreintes digitales présente par exemple plus de dix OLED.

Dans tout le texte, une OLED désigne une diode électroluminescente organique dont l'allumage et l'extinction sont pilotés par une différence de potentiel de l'ordre de quelques volts, entre une électrode supérieure et une électrode inférieure encadrant un empilement de couche(s) semi-conductrice(s) organique(s).

La technologie OLED offre notamment une grande souplesse en terme de dimensionnement, de longueur d'onde d'émission, de largeur du pic d'émission, etc.

En particulier, les OLED peuvent présenter un pas de répétition inférieur à 1 mm, voire 500 µm ou moins. Elles peuvent en outre être très proches les unes des autres. Par exemple, deux OLED voisines peuvent être espacées de moins de 10 µm l'une de l'autre, voire moins de 5 µm, voire adjacentes.

Un autre avantage est qu'elles peuvent être déposées à basse température (environ 80-100 °C), ce qui n'implique pas d'incompatibilité notoire avec d'autres technologies mises en œuvre dans le capteur d'empreintes selon l'invention.

Les OLED 101 sont disposées au-dessus d'un capteur optique matriciel 120. En d'autres termes, les moyens d'éclairage selon l'invention et le capteur optique matriciel sont alignés selon un axe (OZ) orthogonal au plan (XOY).

Le capteur optique matriciel 120 est formé d'une pluralité de photo-détecteurs 102 disposés selon une grille. La grille présente de préférence un maillage carré à N lignes et M colonnes. Chaque photo-détecteur 102 correspond à un pixel du capteur optique matriciel 102. La figure 1B illustre notamment une ligne de pixels du capteur optique matriciel 120. La figure 1C illustre notamment une colonne de pixels du capteur optique matriciel 120.

L'étendue des lignes définit la largeur L1 de la surface de détection 125 du capteur optique matriciel. L'étendue des colonnes définit la longueur L2 de la surface de détection du capteur optique matriciel. La largeur L1 de la surface de détection 125 du capteur optique matriciel est alignée avec l'axe (OY). La longueur L2 du capteur d'empreintes digitales 100 est alignée avec l'axe (OX). Le plus grand côté du capteur optique matriciel peut être indifféremment la longueur ou la largeur. Le pas de pixel du capteur optique matriciel est par exemple 50 µm, ou 25 µm.

La surface de détection 125 est encadrée en traits pointillés à la figure 1A, et symbolisée par un trait mixte sur les figures 1B et 1C.

Les photo-détecteurs 102 sont par exemple des diodes PiN (pour « *P-Type Intrinsic N-Type* ») réalisées en matériau inorganique tel que le silicium par exemple. En variante, les photo-détecteurs sont des photo-détecteurs organiques (dits OPD), ou des phototransistors, ou tout autre élément photosensible.

Des unités de pilotage de ces photo-détecteurs sont réalisées ici en technologie de transistors à couches minces, dite TFT pour « *Thin-Film Transistor* », sur un substrat 130 en verre.

L'invention n'est bien sûr pas limitée à cette technologie TFT. Elle est transposable à d'autres technologies, notamment la technologie CMOS (pour « *Complementarity Metal-Oxide-Semiconductor* ») ou même l'électronique imprimée. Le substrat peut être en silicium, en métal, en plastique notamment pour réaliser un capteur d'empreintes papillaires flexible, etc.

Le capteur optique matriciel 120 est configuré pour détecter un signal optique émis par les OLED 101 et rétrodiffusé sur un obstacle, ici un doigt.

Les OLED 101 sont disposées au-dessus du capteur optique matriciel 120.

En particulier, les OLED sont disposées du côté du capteur optique matriciel opposé au substrat 130, c'est-à-dire du côté de la surface de détection 125 du capteur optique matriciel 120. La surface de détection correspond à la surface sur laquelle s'étendent les photo-détecteurs 102, dans un plan parallèle au plan (XOY).

Cette disposition permet de favoriser la quantité de lumière arrivant dans la peau, en d'autres termes les tissus, et de minimiser la diffusion de la lumière avant d'atteindre l'empreinte papillaire.

Il y a peu de lumière pouvant aller directement des OLED vers les pixels du capteur optique matriciel. Et même s'il y en avait, il suffirait de ne pas exploiter les pixels situés directement sous les OLED allumées.

Les OLED 101 partagent avec le capteur optique matriciel 120 le même substrat 130. En d'autres termes, les OLED 101 et le capteur optique matriciel 120 sont intégrés sur un même substrat.

Ainsi, les OLED et le capteur optique matriciel peuvent être réalisés au cours d'un unique processus de fabrication. En particulier, au lieu de fabriquer l'un puis l'autre sur un substrat dédié, puis de les coller ensemble, on peut réaliser le capteur optique matriciel par dépôt de couches sur un substrat, puis les OLED par dépôt de couches directement au-dessus du même substrat.

Dans l'exemple représenté, une couche de planarisation 140 recouvre directement les photo-détecteurs 102, les OLED étant déposées directement sur cette couche de planarisation.

Dans le premier mode de réalisation illustré sur les figures 1A à 1C, les OLED 101 s'étendent chacune d'un seul tenant selon (OY), sensiblement sur toute la largeur L1 de la surface de détection 125 du capteur optique matriciel, par exemple au moins 90% de cette largeur.

Dans l'exemple illustré sur les figures 1A à 1C, elles s'étendent même au-delà de la surface de détection du capteur optique matriciel, ce qui présente l'avantage de limiter des effets de bord sur les images acquises. En d'autres termes, elles s'étendent au-dessus de ladite surface de détection, en dépassant de part et d'autre de cette dernière dans un plan (XOY).

Ici, les OLED présentent toutes une même étendue selon l'axe (OY).

Dans l'exemple représenté sur les figures 1A à 1C, elles présentent également les mêmes dimensions selon (OX) et (OZ).

Elles s'étendent selon des motifs parallèles entre eux, ici selon des bandes parallèles entre elles.

En variante, chaque motif présente une forme en trapèze, ou en zigzag notamment sinusoïdal, ou toute autre forme allongée selon (OY).

Les motifs s'étendent ici parallèles en eux et parallèles à l'axe (OY), c'est-à-dire parallèles aux lignes de pixels du capteur optique matriciel.

En variante, les motifs peuvent s'étendre parallèles entre eux et légèrement inclinés relativement à l'axe (OY) et aux lignes de pixels du capteur optique matriciel. Cette inclinaison, inférieure à 8°, permet dans certains cas d'améliorer la résolution des images obtenues.

Les OLED 101 sont réparties selon la longueur L2 de la surface de détection 125 du capteur optique matriciel. Elles sont donc situées les unes sous les autres dans un plan parallèle au plan (XOY), leurs extrémités étant alignées sur un axe parallèle à (OX).

Elles sont donc réparties ici sur une surface de dimensions supérieures ou égales à celles la surface de détection 125 du capteur optique matriciel.

Les OLED sont réparties ici régulièrement selon la longueur L2 de la surface de détection 125 du capteur optique matriciel, avec un pas de répétition P1 égal au pas de pixel du capteur optique matriciel selon l'axe (OX).

Chaque OLED est connectée à une unité de pilotage 111, configurée pour piloter l'allumage et l'extinction de chaque OLED selon un principe d'adressage que l'on trouve en technologie de type AMOLED (pour « *Active Matrix OLED »).*

Les unités de pilotage 111 s'étendent intégralement à l'extérieur de la surface de détection 125, le long d'un côté de celle-ci, parallèle à (OX).

Chaque unité de pilotage 111 comprend au moins un transistor, formé ici en sur le substrat 130, en périphérie du capteur optique matriciel. Sur la grille de chaque transistor, on peut connecter des drivers de pilotage, par exemple pour piloter des séquences d'allumage et extinction prédéterminées.

Les unités de pilotage 111 sont alignées les unes à la suite des autres selon l'axe (OX), c'est-à-dire selon un axe orthogonal à l'axe d'allongement des OLED.

Les unités de pilotage 111 sont placées d'un côté d'une OLED, selon son axe d'allongement, des deux côtés d'une OLED selon son axe d'allongement, ou réparties entre les deux (ce qui permet de limiter leur pas de répétition de chaque côté des OLED).

Ici, les transistors sont réalisés en technologie TFT, et réalisés en même temps que des transistors nécessaires au fonctionnement du capteur optique matriciel.

En variante, les unités de pilotage ne sont pas réalisées sur le substrat 130, mais déportées de celui-ci, et connectées en périphérie de celui-ci à un contact électrique relié à une OLED. Elles sont par exemple réalisées en technologie CMOS, connectées et le cas échéant fixées en périphérie du substrat 130. Là encore, elles s'étendent intégralement à l'extérieur de la surface de détection 125.

Dans les matrices AMOLED de l'art antérieur, les OLED sont formées selon une matrice à plusieurs lignes et plusieurs colonnes, et chaque unité de pilotage est disposée à proximité de l'OLED correspondante, à l'intérieur de la grille d'OLED. Avec une telle matrice AMOLED, les unités de pilotage s'étendraient donc à l'intérieur de la surface de détection 125.

Lorsque les unités de pilotage sont réalisées sur un même substrat avec le capteur optique matriciel, l'invention permet alors de libérer, au centre de la surface de détection, des emplacements pour des transistors dédiés au capteur optique matriciel et non au pilotage des OLED.

En fonctionnement, l'utilisateur pose le doigt directement sur le capteur d'empreintes digitales, en contact physique direct avec une surface de contact 106 de celui-ci. La peau (ou du moins la peau des crêtes de l'empreinte papillaire) est donc en contact direct avec la surface de contact 106.

La surface de contact 106 est une partie de la surface externe du capteur optique matriciel, située au-dessus des OLED et du capteur optique matriciel.

La surface de contact 106 peut appartenir à la surface supérieure d'une fine couche de protection 107 recouvrant les OLED.

En variante, la surface de contact appartient simplement à une électrode supérieure couvrant les OLED.

La surface de contact 106 est de préférence plane, parallèle au plan (XOY).

Le cas échéant, des interstices entre OLED voisines sont comblés par un matériau transparent.

Afin de limiter des effets de diffusion entre le doigt et le capteur optique matriciel, la distance H1 entre celui-ci et la surface de contact 106 doit être entre 1 µm et 20 µm.

La hauteur H1 est mesurée selon (OZ), entre le plan recevant les sommets des photo-détecteurs 102, et le plan recevant les sommets de la surface de contact, les sommets de la surface de contact étant situés au-dessus des OLED.

Les OLED sont intercalées dans cet espace de hauteur H1. Par conséquent, l'épaisseur des OLED selon (OZ) est avantageusement inférieure à 25 µm et même 20 µm.

Pour des raisons de lisibilité des figures, la surface de contact n'est pas forcément représentée sur les figures suivantes.

En fonctionnement, toutes les OLED ne sont pas allumées simultanément, et on peut ne traiter que les pixels du capteur optique matriciel qui ne sont pas situés directement sous une OLED allumée.

Le capteur d'empreinte papillaires selon la présente invention ne nécessite pas l'emploi de microlentilles disposées, sous forme matricielle, entre la surface de contact et le capteur matriciel. Il est ainsi possible de considérer un dipositif plus compact, permettant également d'obtenir des images d'empreintes papillaires avec un meilleur contaste. En particulier, une distance H1 inférieure à 25 µm permet d'augmenter l'ouverture numérique du capteur selon la présente invention.

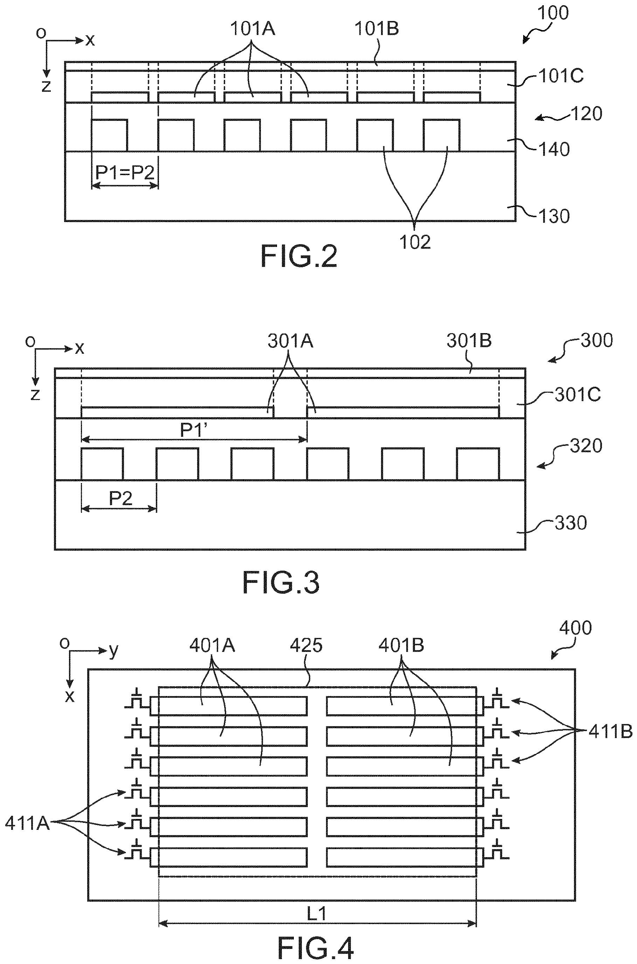

La figure 2 illustre de façon un peu plus détaillée le capteur d'empreintes digitales 100, selon une vue en coupe, selon un même plan qu'en figure 1C.

Chaque OLED 101 est définie par l'intersection entre :
- une électrode inférieure 101A, spécifique à ladite OLED (du côté du substrat 130) ;
- une électrode supérieure 101B, commune à toutes les OLED, qui s'étend d'un seul tenant au-dessus de la surface de détection du capteur optique matriciel 120 (électrode la plus éloignée du substrat 130) ; et
- un empilement 101C d'au moins une couche semi-conductrice organique, commune à toutes les OLED, qui s'étend d'un seul tenant au-dessus de la surface de détection du capteur optique matriciel 120.

Chaque OLED selon l'invention est donc définie par l'intersection entre l'électrode supérieure, une électrode inférieure, et l'empilement d'au moins une couche semi-conductrice organique.

En particulier, l'étendue d'une OLED dans un plan parallèle au plan (XOY) correspond à l'intersection entre la projection dans ce plan de l'électrode supérieure, la projection dans ce plan d'une électrode inférieure, et la projection dans ce plan dudit empilement.

Les limites de chaque OLED sont représentées en traits pointillés.

Les dimensions latérales d'une OLED sont ici définies par l'étendue de l'électrode inférieure 101A dans le plan (XOY), ce qui donne accès à de faibles dimensions des OLED selon (OX), par exemple moins de 20 µm, notamment 10 µm. En outre, les contraintes spatiales lors du dépôt de l'empilement 101C sont réduites.

L'ensemble est recouvert d'une couche de protection, également nommée couche d'encapsulation, non représentée. La surface supérieure de cette couche de protection forme la surface externe du capteur d'empreinte digitales, comprenant la surface de contact sur laquelle l'utilisateur pose son doigt pour la lecture d'empreinte.

L'empilement 101C qui s'étend pleine couche au-dessus du capteur optique matriciel 120, est transparent sur une bande spectrale d'émission des OLED. Le coefficient de transmission sur cette bande spectrale est par exemple supérieur à 70%. Il peut être supérieur à 70%, entre 450 et 750 nm.

Il en est de même pour l'électrode supérieure 101B, qui peut être un métal mince ou de l'ITO (Oxyde d'indium-étain).

Selon une variante non représentée, l'empilement d'au moins une couche semi-conductrice organique est spécifique à chaque OLED. Les empilements des plusieurs OLED sont réalisés par exemple par dépôt de couche à travers un masque.

Les électrodes inférieures 101A sont opaques à la longueur d'onde d'émission de l'OLED (coefficient de transmission par exemple inférieur à 30% entre 450 et 750 nm). Cela évite que l'émission lumineuse fournie par l'OLED soit émise directement vers le capteur optique matriciel, sans réflexion sur l'empreinte à imager. Cependant, on peut tolérer que le pixel sous l'OLED soit ébloui, puisqu'en fonctionnement toutes les OLED ne seront pas allumées simultanément. On peut augmenter le rendement d'une OLED avec des électrodes inférieures 101 réfléchissantes, par exemple avec un coefficient de réflexion supérieur à 70% entre 450 et 750 nm.

Dans l'exemple représenté en figure 2, le pas de répétition des OLED est constant, et égal au pas de pixel du capteur optique matriciel selon (OX).

En d'autres termes, à chaque OLED correspond une ligne de pixels du capteur optique matriciel 120.

La figure 3 illustre une variante dans laquelle le pas de répétition P1' des OLED est constant, et distinct du pas de pixel P2 pixel du capteur optique matriciel selon (OX).

Les références numériques de la figure 3 correspondent à celles de la figure 1, le premier chiffre étant remplacé par un 3.

En particulier, le pas de répétition P1' est un multiple entier de P2.

Par exemple P2 est de l'ordre de 50 µm, voire 25 µm, et P1' est entre 10 et 20 fois supérieur, par exemple de l'ordre de 500 µm, de préférence moins d'un millimètre.

Chaque OLED peut alors s'étendre au-dessus de plusieurs lignes de pixels du capteur optique matriciel 320.

Les différentes OLED peuvent être proches les unes des autres. Par exemple, les bords voisins de deux OLED voisines sont espacés d'une distance inférieure à la largeur d'un pixel du capteur optique matriciel selon l'axe (OX), notamment inférieure à 25 µm ou même 10 µm.

La figure 4 illustre un troisième mode de réalisation d'un capteur d'empreintes papillaires selon l'invention.

Ce mode de réalisation ne sera décrit que pour ses différences relativement au mode de réalisation des figures 1A à 1C.

Selon ce mode de réalisation, les OLED sont réparties en deux séries.

Une première série d'OLED 401A s'étend sur la partie gauche du capteur d'empreintes digitales 400.

Elle est constituée d'OLED qui s'étendent chacune d'un seul tenant sur environ la moitié de la surface de détection 425 du capteur optique matriciel.

Elles s'étendent en particulier au-dessus de ladite surface de détection, depuis le milieu de celle-ci dans le sens de la largeur L1, jusqu'au bord de cette surface de détection et même au-delà, dans l'exemple de la figure 4.

Cette première série d'OLED est pilotée par des unités de pilotage 411A, disposées sur le bord gauche du substrat.

Une deuxième série d'OLED 401B s'étend sur la partie droite du capteur d'empreintes digitales 400.

La deuxième série d'OLED 401B est le symétrique de la première série d'OLED 401A relativement à un plan parallèle à (XOZ) passant par le milieu de la surface de détection 425, dans le sens de sa largeur L1.

Cette deuxième série d'OLED 401B est pilotée par des unités de pilotage 411B, disposées sur le bord droit du substrat.

Chaque OLED 401A de la première série d'OLED, et son symétrique 401B dans la deuxième série d'OLED, sont espacées d'une distance qui n'excède pas un tiers de la largeur L1 de la surface de détection 425, de préférence seulement quelques micromètres.

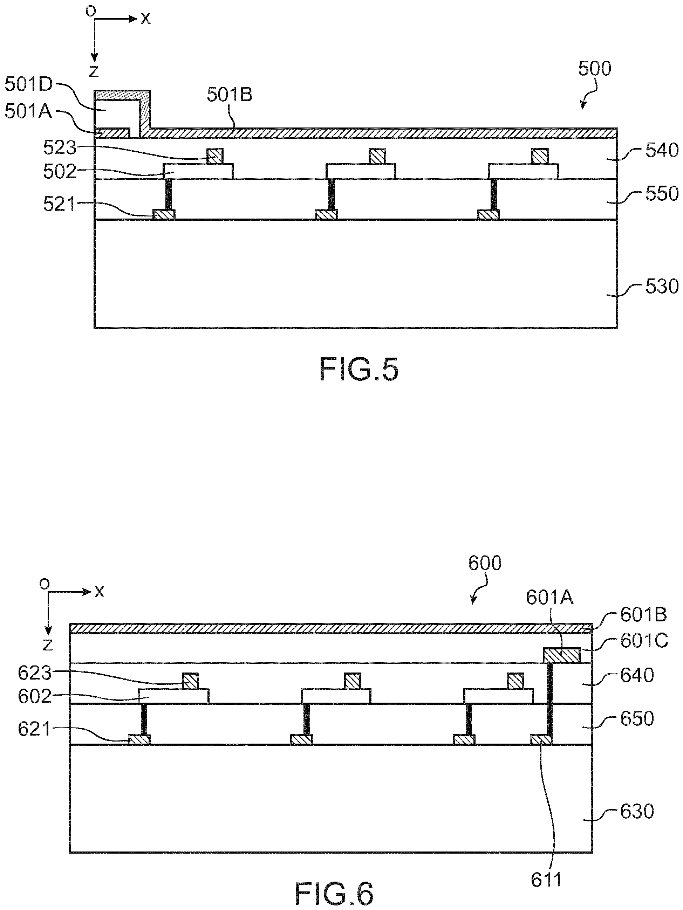

Les figures 5 et 6 illustrent deux modes de réalisation d'un capteur d'empreintes digitales selon l'invention, comprenant des moyens de pilotage des OLED, représentés selon une vue en coupe dans un plan parallèle à (XOZ).

On illustre ici plus particulièrement les circuits de pilotage des OLED et des photo-détecteurs du capteur optique matriciel, réalisés selon une technologie TFT, sur un substrat 530 en verre.

Le capteur optique matriciel est constitué de photo-détecteurs 502, ici des diodes PiN.

Chaque photo-détecteur 502 est connecté à un transistor 521, assurant la lecture puis la réinitialisation de celui-ci.

Les transistors 521 sont formés directement sur le substrat en verre 530, séparés des photo-détecteurs par une couche isolante 550. Une connexion s'étend à travers cette couche isolante pour relier chaque transistor 521 à un photo-détecteur 502.

Au-dessus de chaque photo-détecteur 502, en contact direct avec celui-ci, un connecteur métallique 523 permet de polariser celui-ci.

Le photodetecteur possède une électrode supérieure transparente.

La surface supérieure de chaque photo-détecteur 502 forme une zone photosensible du capteur optique matriciel.

L'ensemble est recouvert d'une seconde couche d'isolation 540, qui peut être planarisée avant de former les OLED.

Dans le mode de réalisation de la figure 5, chaque OLED présente un empilement spécifique 501D de couches semi-conductrices organiques.

Une OLED est alors définie par l'intersection entre une électrode inférieure spécifique 501A, l'empilement de couches semi-conductrices organiques 501D, et l'électrode supérieure 501B commune à toutes les OLED.

Les électrodes inférieures 501A sont formées directement sur la couche d'isolation 540.

Chaque empilement 501D de couches semi-conductrices organiques 501D est formé directement sur une électrode inférieure 501A.

Une électrode supérieure 501B recouvre l'ensemble, en s'étendant à la fois sur les empilements 501D et sur la couche d'isolation 540.

Les électrodes inférieures 501A peuvent être formées par dépôt de couche à travers un masque, ou, pour obtenir de plus petites dimensions selon (OX), par dépôt d'une couche sur toute la surface de la couche 540, puis lithographie et gravure.

Les empilements 501D peuvent être réalisés par dépôt de couche à travers un masque, par exemple un masque métallique dit « shadow mask ». La dimension de chaque empilement 501D selon l'axe (OX) est inférieure à 20 µm, voire 10 µm.

L'électrode supérieure 501B est déposée directement sur la couche 540, ou directement sur les empilements 501D, là où ils sont présents.

Selon une variante avantageuse, elle est déposée à travers un masque, dans la foulée, et dans le même pompage que le dépôt d'OLED.

Dans cette configuration, les empilements 501D s'étendent chacun au-dessus du capteur optique matriciel, sans recouvrir les photo-détecteurs 502. En d'autres termes, ils s'étendent uniquement entre deux rangées de photo-détecteurs 502.

Dans l'exemple illustré en figure 5, le pas de répétition des OLED est supérieur au pas de pixel, de sorte qu'on a illustré une seule OLED pour trois pixels du capteur optique matriciel.

De cette façon, ils peuvent être opaques sans que cela ne perturbe la détection, par les photo-détecteurs, d'un signal émis par les OLED et rétrodiffusé sur un tissu humain présentant une empreinte papillaire, par exemple un doigt.

De la même façon, l'électrode inférieure 501A peut être opaque, et réfléchissante, de sorte que les OLED n'émettent pas en direction du substrat 530.

L'ensemble est recouvert d'une couche d'encapsulation par film mince.

Dans cet exemple, les moyens de pilotage des OLED ne sont pas intégrés sur le substrat 530.

Les électrodes sont reliées chacune à un connecteur métallique disposé en bord de substrat, et une connexion filaire (non représentée) relie ces connecteurs métalliques à des moyens de pilotage déportés

En variante, des transistors de pilotage des OLED sont intégrés sur le bord du substrat 530, en dehors de la surface de détection, comme détaillé ci-avant.

La figure 6 illustre une variante du mode de réalisation de la figure 5, qui ne sera décrite que pour ses différences relativement à la figure 5. Les références numériques de la figure 6 correspondent aux références numériques de la figure 5, le premier chiffre étant remplacé par un 6.

Ici, l'empilement 601C de couches semi-conductrices organiques est commun à toutes les OLED, comme illustré en figure 3.

Chaque OLED est connectée à un transistor 611 formant une unité de pilotage, et intégré sur le substrat 630. Une connexion s'étend à travers la couche isolante 650 pour relier chaque transistor 611 à l'électrode inférieure 601A d'une OLED.

Les transistors 611 sont formés sur le substrat 630, en bordure de la surface de détection.

En variante, bien que cela soit moins intéressant du point de vue encombrement comme expliqué précédemment, on pourrait également disposer les transistors au centre du substrat.

Chaque OLED est avantageusement monochrome, c'est-à-dire configurée pour émettre un rayonnement de largeur spectrale inférieure à 80 nm, par exemple dans le bleu, ou dans le rouge, ou dans le vert.

Au moins deux OLED peuvent être configurées pour émettre à des longueurs d'onde respectives différentes l'une de l'autre.

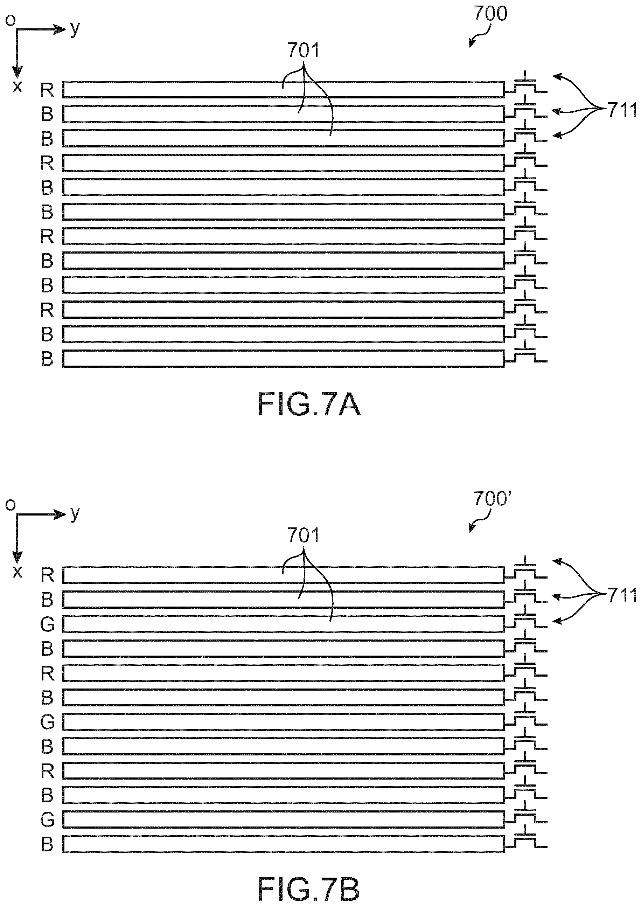

La figure 7A illustre, selon une vue de dessus et de manière schématique, un exemple d'un capteur d'empreintes digitales 700 dans lequel au moins deux OLED sont configurées pour émettre à des longueurs d'onde respectives différentes l'une de l'autre.

Un premier type d'OLED, noté B, est configuré pour émettre un rayonnement dans le bleu, à une longueur d'onde comprise entre 400 et 495 nm.

Un second type d'OLED, noté R, est configuré pour émettre un rayonnement dans le rouge, à une longueur d'onde comprise entre 620 et 750 nm.

On peut ainsi caractériser au mieux un échantillon présentant une empreinte papillaire, en étudiant un rayonnement rétrodiffusé par cet échantillon, et pour plusieurs longueurs d'onde situées de préférence dans le visible. En effet, la peau absorbe plus ou moins en fonction de la longueur d'onde. Ici, les deux longueurs d'onde choisies sont situées sensiblement aux deux extrémités du spectre visible. Plus particulièrement, l'absorption des tissus vivants (par de la peau) présente une forte variation à la longueur d'onde 600 nm. Ainsi la considération d'un premier et d'un second type d'OLED configurés pour émettre un rayonnement lumineux à des longueurs d'ondes, respectivement, inférieures et supérieures à 600 nm, permet de considérer l'extraction d'au moins deux informations sensiblement différentes.

Puisque la lumière rouge se propage plus loin dans les tissus vivants, les OLED dites R, émettant dans le rouge, peuvent être plus espacées les unes des autres que les OLED dites B, émettant dans le bleu.

Dans l'exemple illustré en figure 7A, toutes les OLED sont de mêmes dimensions et régulièrement espacées les unes des autres. Les OLED forment ensemble un agencement périodique, avec un motif élémentaire multi-spectral comprenant deux OLED émettant dans le bleu et une OLED émettant dans le rouge. Ainsi, le pas de répétition moyen d'une OLED émettant dans le bleu est inférieur au pas de répétition moyen d'une OLED émettant dans le rouge.

Selon une variante non représentée, les différents types d'OLED, qui diffèrent par leur longueur d'onde d'émission, présentent une étendue selon (OX) qui dépend de la longueur d'onde centrale d'émission. Plus cette longueur d'onde est faible, plus l'étendue selon OX est faible.

Sur la figure 7A, on a également représenté de manière schématique des unités de pilotage 711 comprenant chacune un transistor.

La figure 7B illustre une variante dans laquelle le capteur d'empreintes digitales 700' comprend des moyens d'éclairage qui présentent trois types d'OLED.

Un premier type d'OLED, noté B, est configuré pour émettre un rayonnement dans le bleu, à une longueur d'onde comprise entre 400 et 495 nm.

Un deuxième type d'OLED, noté G, est configuré pour émettre un rayonnement dans le vert, à une longueur d'onde comprise entre 495 et 570 nm, plus particulièrement entre 500 et 570 nm.

Un troisième type d'OLED, noté R, est configuré pour émettre un rayonnement dans le rouge, à une longueur d'onde comprise entre 620 et 750 nm.

Les OLED émettant dans le bleu, dans le vert, et dans le rouge forment ensemble un agencement périodique, avec un motif élémentaire multi-spectral comprenant deux OLED du premier type (émettant dans le bleu), une OLED du deuxième type (émettant dans le vert) et une OLED du troisième type (émettant dans le rouge).

En particulier, chaque OLED émettant dans le bleu qui est encadrée par deux OLED, est encadrée par une OLED émettant dans le rouge et une OLED émettant dans le vert.

Ainsi, le pas de répétition des OLED émettant dans le bleu est là-encore moins élevé que celui des autres types d'OLED (1 OLED sur 2 émet dans le bleu, une sur 4 émet dans le rouge, une sur 4 émet dans le vert).

On pourra imaginer toutes sortes de variantes, notamment des variantes comprenant des OLED émettant en dehors du spectre visible, par exemple dans le proche infrarouge (entre 700 et 950 nm) ou le proche ultra-violet (entre 350 et 440 nm).

Chaque OLED peut être recouverte d'un filtre chromatique, pour affiner une longueur d'onde émise en direction de l'empreinte papillaire.

Une étendue des motifs élémentaires selon l'axe (OX) est de préférence inférieure ou égale à 10 mm, par exemple comprise entre 3 mm et 10 mm, voire entre 3 mm et 5 mm.

En fonctionnement, on peut n'allumer simultanément que des OLED émettant à la même longueur d'onde.

On peut mettre en œuvre un balayage de sorte que chaque OLED soit allumée exactement une fois et éteinte sinon. En variante, on allume simultanément des séries de plusieurs OLED.

Les OLED de différentes couleurs pourront être réalisées de différentes façons.

Par exemple, la longueur d'onde d'émission d'une OLED est fonction de la nature de l'empilement de couches semi-conductrice organiques correspondant.

Après avoir structuré les électrodes inférieures, on dépose successivement les empilements de couches semi-conductrices organiques de différentes natures, au travers de différents masques. Par exemple, on dépose un empilement pour une émission dans le bleu, en masquant les électrodes inférieures dédiées à l'émission dans le rouge et dans le vert. Ensuite, on déplace le masque et on dépose un empilement pour une émission dans le rouge, en masquant les électrodes inférieures dédiées à l'émission dans le bleu et dans le vert. On fait de même pour l'émission dans le vert.

En variante, la longueur d'onde d'émission d'une OLED est fonction de la nature d'un filtre spectral recouvrant l'électrode supérieure et faisant partie intégrante de l'OLED selon l'invention.

Par exemple, après avoir structuré les électrodes inférieures, on dépose un unique empilement de couches semi-conductrices organiques pour une émission dans le blanc, et on recouvre le tout par l'électrode supérieure commune. Ensuite, on dépose et on grave des couches filtrantes successives au regard des électrodes inférieures. Cette technique est très précise, et permet de réaliser des OLED monochromatiques de quelques microns seulement selon (OX), l'OLED comprenant alors le filtre spectral recouvrant l'électrode supérieure.

Selon une autre variante, la longueur d'onde d'émission d'une OLED est fonction d'une tension d'alimentation qui lui est appliquée.

Cette variante est adaptée pour réaliser deux types d'OLED. Après avoir structuré les électrodes inférieures, on dépose un unique empilement de couches semi-conductrices organiques pouvant présenter deux longueurs d'onde centrales d'émission, et on recouvre le tout par l'électrode supérieure commune. Ensuite, chaque OLED émettra dans l'une ou l'autre longueur d'onde selon la tension appliquée à l'électrode inférieure correspondante. Par exemple, elle émettra du vert à 3 V, et du bleu pour une tension supérieure à 4 V. Cette technique permet également de réaliser des OLED de quelques microns seulement selon (OX).

Le capteur d'empreintes digitales ainsi réalisé pourra être utilisé pour obtenir une image de ladite empreinte présentant une qualité améliorée, relativement aux images obtenues selon l'art antérieur.

En particulier, en allumant différentes combinaisons d'OLED, on acquiert une série d'images qui peuvent être combinées pour s'affranchir de défauts tels que l'effet de l'éclairage ambiant, une saturation de pixels, des salissures sur le capteur d'empreintes digitales, etc.

Le capteur d'empreintes digitales selon l'invention peut également être utilisé pour discriminer un tissu vivant d'une imitation, en calculant des coefficients d'absorption et de diffusion d'un échantillon imagé, à partir d'au moins une image acquise pour au moins un motif d'allumage et extinction des OLED.

## Revendications

1. Capteur d'empreintes papillaires (100 ; 300 ; 400 ; 500 ; 600 ; 700 ; 700') comprenant superposés, une surface de contact pour y appliquer l'empreinte à imager, des moyens d'éclairage et un capteur optique matriciel (120 ; 320), le capteur optique matriciel (120 ; 320) comprenant une pluralité de photo-détecteurs (102) disposés selon des lignes et des colonnes, avec l'étendue des lignes et l'étendue des colonnes qui définissent respectivement une largeur (L1) et une longueur (L2) d'une surface de détection du capteur optique matriciel (120 ; 320), avec les moyens d'éclairage disposés entre ladite surface de contact et la surface de détection (125 ; 425) du capteur optique matriciel, et constitués d'une pluralité de diodes électroluminescentes organiques (101; 401A, 401B ; 701), dites OLED, chaque OLED s'étendant d'un seul tenant sur plus d'un tiers de la largeur (L1) de ladite surface de détection, et les OLED s'étendant ensemble selon une ou deux séries de motifs parallèles entre eux répartis selon la longueur (L2) de la surface de détection, avec les OLED intercalées entre le capteur optique matriciel et la surface de contact, **caractérisé en ce qu'**une distance (H1) entre le capteur optique matriciel (120; 320) et la surface de contact (106) est comprise entre 1 µm et 20 µm, avec les OLED et le capteur optique matriciel (120 ; 130) intégrés sur un même substrat, et avec la surface de contact (106) qui appartient à la surface supérieure d'une fine couche de protection recouvrant les OLED ou à une électrode supérieure couvrant les OLED.

2. Capteur (100; 300; 400; 500; 600; 700; 700') selon la revendication 1, **caractérisé en ce que** chaque OLED (101 ; 401A, 401B ; 701) est reliée à une unité de pilotage (111 ; 411A, 411B ; 611; 711), agencée pour piloter l'allumage et l'extinction de l'OLED, une projection orthogonale des unités de pilotage dans le plan de la surface de détection (125 ; 425) étant située à l'extérieur de ladite surface de détection.

3. Capteur (100 ; 300 ; 500 ; 600 ; 700 ; 700') selon la revendication 1 ou 2, **caractérisé en ce que** chaque OLED s'étendant d'un seul tenant sur plus de 90% de la largeur (L1) de ladite surface de détection (125), les OLED s'étendant ensemble selon une unique série de motifs parallèles entre eux.

4. Capteur (700 ; 700') selon l'une quelconque des revendications 1 à 3, **caractérisé en ce que** les moyens d'éclairage sont constitués d'OLED (701) de différents types, qui diffèrent par la longueur d'onde centrale du rayonnement lumineux qu'elles sont adaptées à émettre.

5. Capteur (700 ; 700') selon la revendication 4, **caractérisé en ce que** les OLED comprennent chacune un filtre spectral et partagent ensemble une même couche semi-conductrice organique adaptée à émettre un rayonnement multi-spectral, et en ce les différents types d'OLED diffèrent par la longueur d'onde centrale de la bande de transmission du filtre spectral.

6. Capteur (700 ; 700') selon la revendication 4, **caractérisé en ce que** chaque OLED présente deux longueurs d'onde centrales d'émission distincte, selon la valeur d'une tension de polarisation qui lui est appliquée, et **en ce que** les différents types d'OLED diffèrent par la tension de polarisation fournie par une unité de pilotage connectée à l'OLED.

7. Capteur (700) selon l'une quelconque des revendications 4 à 6, **caractérisé en ce que** les diodes électroluminescentes organiques comprennent au moins un premier type de diode électroluminescente organique (701), adapté à émettre un rayonnement lumineux de longueur d'onde centrale inférieure à 590 nm, et un deuxième type de diode électroluminescente organique (701), adapté à émettre un rayonnement lumineux de longueur d'onde centrale supérieure à 600 nm.

8. Capteur (700') selon l'une quelconque des revendications 4 à 6, **caractérisé en ce que** les OLED comprennent :
- un premier type d'OLED (701), adapté à émettre un rayonnement lumineux de longueur d'onde centrale comprise entre 400 et 495 nm,
- un deuxième type d'OLED (701), adapté à émettre un rayonnement lumineux de longueur d'onde centrale comprise entre 495 et 590 nm, et
- un troisième type de d'OLED (701), adapté à émettre un rayonnement lumineux de longueur d'onde centrale supérieure à 600 nm.

9. Capteur (700) selon l'une quelconque des revendications 4 à 8, **caractérisé en ce que** les OLED forment ensemble un agencement périodique, avec un motif élémentaire comprenant lesdits plusieurs types d'OLED (701).

10. Capteur (700) selon l'une quelconque des revendications 4 à 9, **caractérisé en ce que** les OLED (701) forment ensemble un agencement périodique, avec un motif élémentaire tel que le pas de répétition moyen d'un type d'OLED adapté à émettre à une première longueur d'onde est inférieur au pas de répétition moyen d'un type d'OLED adapté à émettre à une seconde longueur d'onde supérieure à la première longueur d'onde.

11. Capteur (100; 300; 400; 500; 600; 700; 700') selon l'une quelconque des revendications 1 à 10, **caractérisé en ce que** chaque OLED (101 ; 401A, 401B ; 701) présente une forme de bande, les OLED formant ensemble des bandes parallèles entre elles.

12. Capteur (500) selon l'une quelconque des revendications 1 à 11, **caractérisé en ce que** chaque OLED s'étend au-dessus du capteur optique matriciel, sans recouvrir les zones photosensibles (502) des pixels du capteur optique matriciel.

13. Capteur (100 ; 300 ; 400 ; 600 ; 700 ; 700') selon l'une quelconque des revendications 1 à 11, **caractérisé en ce que** les OLED (101 ; 401A, 401B ; 701) sont transparentes et s'étendent au-dessus du capteur optique matriciel (120 ; 320) en recouvrant les zones photosensibles des pixels dudit capteur.

14. Capteur (100; 400; 600; 700; 700') selon l'une quelconque des revendications 1 à 13, **caractérisé en ce que** les OLED (101; 401A, 401B ; 701) sont réparties régulièrement selon la longueur (L2) de la surface de détection du capteur optique matriciel, avec un pas de répétition (P1) égal au pas de pixel (P2) du capteur optique matriciel selon ladite longueur.

## Patentansprüche

1. Sensor für Fingerabdrücke (100; 300; 400; 500; 600; 700; 700'), übereinander angeordnet umfassend, eine Kontaktfläche, um darauf den abzubildenden Abdruck, Beleuchtungsmittel und einen optischen Matrizensensor (120; 320) zu applizieren, wobei der optische Matrizensensor (120; 320) eine Vielzahl von Photodetektoren (102) umfasst, die entlang von Zeilen und Spalten angeordnet sind, mit der Ausdehnung der Zeilen und der Ausdehnung der Spalten, die jeweils eine Breite (L1) und eine Länge (L2) einer Erfassungsfläche des optischen Matrizensensors (120; 320) definieren, wobei die Beleuchtungsmittel zwischen der Kontaktfläche und der Erfassungsfläche (125; 425) des optischen Matrizensensors angeordnet sind und aus einer Vielzahl organischer Leuchtdioden (101; 401A, 401B; 701) bestehen, OLEDs genannt, wobei sich jede OLED einstückig über mehr als ein Drittel der Breite (L1) der Erfassungsfläche erstreckt, und die OLEDs erstrecken sich zusammen entlang einer oder zwei Reihen von zueinander parallelen Mustern und sind entlang der Länge (L2) der Erfassungsfläche verteilt, mit den OLEDs, die zwischen dem optischen Matrizensensor und der Kontaktfläche zwischengeschalten sind, **dadurch gekennzeichnet, dass** ein Abstand (H1) zwischen dem optischen Matrizensensor (120; 320) und der Kontaktfläche (106) zwischen 1 µm und 20 µm beträgt, mit den OLEDs und dem optischen Matrizensensor (120; 130), die auf demselben Substrat integriert sind, und der Kontaktfläche (106), die zur oberen Oberfläche einer dünnen Schutzschicht gehört, die die OLEDs bedeckt, oder zu einer oberen Elektrode, die die OLEDs abdeckt.

2. Sensor (100; 300; 400; 500; 600; 700; 700') nach Anspruch 1, **dadurch gekennzeichnet, dass** jede OLED (101; 401A, 401B; 701) mit einer Steuereinheit (111; 411A, 411B; 611; 711) verbunden ist, eingerichtet, um das Einschalten und das Ausschalten der OLED zu steuern, wobei sich eine orthogonale Projektion der Steuereinheiten in der Ebene der Erfassungsfläche (125; 425) außerhalb der Erfassungsfläche befindet.

3. Sensor (100; 300; 500; 600; 700; 700') nach Anspruch 1 oder 2, **dadurch gekennzeichnet, dass** sich jede OLED einstückig über mehr als 90 % der Breite (L1) der Erfassungsfläche (125) erstreckt, wobei sich die OLEDs zusammen entlang einer einzigen Reihe von zueinander parallelen Mustern erstrecken.

4. Sensor (700; 700') nach einem der Ansprüche 1 bis 3, **dadurch gekennzeichnet, dass** die Beleuchtungsmittel aus OLEDs (701) verschiedener Typen bestehen, die sich durch die zentrale Wellenlänge der Lichtstrahlung unterscheiden, für deren Emittierung sie angepasst sind.

5. Sensor (700; 700') nach Anspruch 4, **dadurch gekennzeichnet, dass** jede der OLEDs einen Spektralfilter umfasst und sich zusammen eine und dieselbe organische halbleitenden Schicht teilen, die für die Emittierung einer Multispektralstrahlung angepasst ist, und dass sich die verschiedenen Typen von OLEDs durch die zentrale Wellenlänge des Übertragungsbandes des Spektralfilters unterscheiden.

6. Sensor (700; 700') nach Anspruch 4, **dadurch gekennzeichnet, dass** jede OLED zwei individuelle zentrale Wellenlängen aufweist, gemäß dem Wert einer Polarisationsspannung, die ihr appliziert wird, und dass sich die verschiedenen OLED-Typen in der Polarisationsspannung unterscheiden, die von einer an die OLED angeschlossene Steuereinheit geliefert wird.

7. Sensor (700) nach einem der Ansprüche 4 bis 6, **dadurch gekennzeichnet, dass** die organischen Leuchtdioden mindestens einen ersten Typ einer organischen Leuchtdiode (701) umfassen, angepasst, um eine Lichtstrahlung mit einer zentralen Wellenlänge von weniger als 590 nm zu emittieren, und einen zweiten Typ einer organischen Leuchtdiode (701), angepasst, um eine Lichtstrahlung mit einer zentralen Wellenlänge von mehr als 600 nm zu emittieren.

8. Sensor (700') nach einem der Ansprüche 4 bis 6, **dadurch gekennzeichnet, dass** die OLEDs umfassen:
- einen ersten OLED-Typ (701), angepasst, um eine Lichtstrahlung mit einer zentralen Wellenlänge zwischen 400 und 495 nm zu emittieren,
- einen zweiten OLED-Typ (701), angepasst, um eine Lichtstrahlung mit einer zentralen Wellenlänge zwischen 495 und 590 nm zu emittieren, und
- einen dritten OLED-Typ (701), angepasst, um eine Lichtstrahlung mit einer zentralen Wellenlänge von mehr als 600 nm zu emittieren.

9. Sensor (700) nach einem der Ansprüche 4 bis 8, **dadurch gekennzeichnet, dass** die OLEDs zusammen eine periodische Anordnung mit einem elementaren Muster bilden, das die mehreren OLED-Typen (701) umfasst.

10. Sensor (700) nach einem der Ansprüche 4 bis 9, **dadurch gekennzeichnet, dass** die OLEDs (701) zusammen eine periodische Anordnung mit einem elementaren Muster bilden, so dass der durchschnittliche Wiederholungsabstand eines OLED-Typs, der für die Emittierung mit einer ersten Wellenlänge angepasst ist, kleiner ist als der durchschnittliche Wiederholungsabstand eines OLED-Typs, der für die Emittierung mit einer zweiten Wellenlänge angepasst ist, die größer als die erste Wellenlänge ist.

11. Sensor (100; 300; 400; 500; 600; 700; 700') nach einem der Ansprüche 1 bis 10, **dadurch gekennzeichnet, dass** jede OLED (101; 401A, 401B; 701) eine Bandform aufweist, wobei die OLEDs zusammen Bänder bilden, die zueinander parallel sind.

12. Sensor (500) nach einem der Ansprüche 1 bis 11, **dadurch gekennzeichnet, dass** sich jede OLED über dem optischen Matrizensensor erstreckt, ohne die lichtempfindlichen Zonen (502) der Pixel des optischen Matrizensensors zu bedecken.

13. Sensor (100; 300; 400; 600; 700; 700') nach einem der Ansprüche 1 bis 11, **dadurch gekennzeichnet, dass** die OLEDs (101; 401A, 401B; 701) transparent sind und sich über dem optischen Matrizensensor (120; 320) erstrecken, die lichtempfindlichen Zonen der Pixel des Sensors bedeckend.

14. Sensor (100; 400; 600; 700; 700') nach einem der Ansprüche 1 bis 13, **dadurch gekennzeichnet, dass** die OLEDs (101; 401A, 401B; 701) gleichmäßig entlang der Länge (L2) der Erfassungsfläche des optischen Matrizensensors verteilt sind, mit einem Wiederholungsabstand (P1), der gleich dem Pixelabstand (P2) des optischen Matrizensensors ist, entlang der Länge.

## Claims

1. Papillary print sensor (100; 300; 400; 500; 600; 700; 700') comprising in superposition, a contact surface to which the print to be imaged is intended to be applied, illuminating means and an array optical sensor (120; 320), the array optical sensor (120; 320) comprising a plurality of photodetectors (102) arranged in rows and columns, with the extent of the lines and the extent of the columns defining respectively a width (L1) and a length (L2) of a detecting surface of the array optical sensor (120, 320), with illuminating means arranged between said contact surface and the detecting surface (125; 425) of the array optical sensor, and consist of a plurality of organic light-emitting diodes (101; 401A, 401B; 701), referred to as OLEDs, each OLED extending uninterruptedly over more than a third of the width (L1) of said detecting surface, and the OLEDs extending together according to one or two series of patterns that are parallel to one another and distributed over the length (L2) of the detecting surface, with the OLEDs arranged between the array optical sensor (120, 320) and the contact surface, **characterized in that** a distance (H1) between the array optical sensor (120; 320) and the contact surface (106) is between 1 µm and 20 µm, with the OLEDs and the array optical sensor (120, 320) integrated on the same substrate, and with the contact surface (106) which belongs to the top surface of a thin protection layer covering the OLEDs or to a top electrode covering the OLEDs.

2. Sensor (100; 300; 400; 500; 600; 700; 700') according to claim 1, **characterized in that** each OLED (101; 401A, 401B; 701) is connected to a control unit (111; 411A, 411B; 611; 711), arranged to control the lighting and the extinguishing of the OLED, an orthogonal projection of the control units in the plane of the detecting surface (125; 425) being located outside said detecting surface.

3. Sensor (100; 300; 500; 600; 700; 700') according to claim 1 or 2, **characterized in that** each OLED extending uninterruptedly over more than 90% of the width (L1) of said detecting surface (125), the OLEDs extending together according to a single series of patterns that are parallel to one another.

4. Sensor (700; 700') according to any one of claims 1 to 3, **characterized in that** the illuminating means are formed of OLEDs (701) of different types, which differ by the central wavelength of the light radiation that they are adapted to emit.

5. Sensor (700; 700') according to claim 4, **characterized in that** the OLEDs each comprise a spectral filter and together share the same organic semiconductor layer adapted to emit a multi-spectral radiation, and **in that** the different types of OLEDs differ by the central wavelength of the transmission band of the spectral filter.

6. Sensor (700; 700') according to claim 4, **characterized in that** each OLED has two separate central emission wavelengths, depending the value of a polarization voltage that is applied to it, and **in that** the different types of OLEDs differ by the polarization voltage supplied by a control unit connected to the OLED.

7. Sensor (700) according to any one of claims 4 to 6, **characterized in that** the organic light-emitting diodes comprise at least one first type of organic light-emitting diode (701), adapted to emit a light radiation with a central wavelength less than 590 nm, and a second type of organic light-emitting diode (701), adapted to emit a light radiation with a central wavelength greater than 600 nm.

8. Sensor (700') according to any one of claims 4 to 6, **characterized in that** the OLEDs comprise:
- a first type of OLED (701), adapted to emit a light radiation with a central wavelength between 400 and 495 nm,
- a second type of OLED (701), adapted to emit a light radiation with a central wavelength between 495 and 590 nm, and
- a third type of OLED (701), adapted to emit a light radiation with a central wavelength greater than 600 nm.

9. Sensor (700) according to any one of claims 4 to 8, **characterized in that** the OLEDs together form a periodical arrangement, with a basic pattern that comprises said several types of OLEDs (701).

10. Sensor (700) according to any one of claims 4 to 9, **characterized in that** the OLEDs (701) together form a periodical arrangement, with a basic pattern such that the average repetition pitch of a type of OLED adapted to emit at a first wavelength is less than the average repetition pitch of a type of OLED adapted to emit at a second wavelength greater than the first wavelength.

11. Sensor (100; 300; 400; 500; 600; 700; 700') according to any one of claims 1 to 10, **characterized in that** each OLED (101; 401A, 401B; 701) has the form of a strip, with the OLEDs together forming strips parallel between them.

12. Sensor (500) according to any one of claims 1 to 11, **characterized in that** each OLED extends above the array optical sensor, without covering the photosensitive areas (502) of the pixels of the array optical sensor.

13. Sensor (100; 300; 400; 600; 700; 700') according to any one of claims 1 to 11, **characterized in that** the OLEDs (101; 401A, 401B; 701) are transparent and extend above the array optical sensor (120; 320) by covering the photosensitive areas of the pixels of said sensor.

14. Sensor (100; 400; 600; 700; 700') according to any one of claims 1 to 13, **characterized in that** the OLEDs (101; 401A, 401B; 701) are regularly distributed along the length (L2) of the detecting surface of the array optical sensor, with a repetition pitch (P1) equal to the pixel pitch (P2) of the array optical sensor along said length.
